# EUROPEAN PATENT APPLICATION

(11) **EP 0 884 538 A2**
(43) Date of publication of application: **16.12.1998**
(21) Application number: 97310446.6
(22) Date of filing: 22.12.1997
(51) Int. Cl.: F24C 15/08, F24C 15/02

(54) **Casing having a door**

(30) Priority: 12.06.1997 KR 9724357
(71) Applicant: Samsung Electronics Co., Ltd., Suwon City, Kyungki-do (KR)
(72) Inventor: Lee, Gi-Hun, Kwonseon-gu, Suwon-city, Kyungki-do (KR); Kim, Sang-Han, Suwon-city, Kyungki-do (KR)
(74) Representative: Geary, Stuart Lloyd

(57) **Abstract**

In order that the upper panel (50) of a casing is not proud of a doo (80), a wall (20), against which the door (80) closes, is provided with a coupling flange (21) below the top of the door (80) on which the upper panel (50) rests. The edge of the upper panel is bent back on itself and has a slot (53) into which a tongue (22) on the flange (21) is inserted.

## Description

The present invention relates to a casing having an upper panel, a wall panel and a door configured to close against the wall panel.

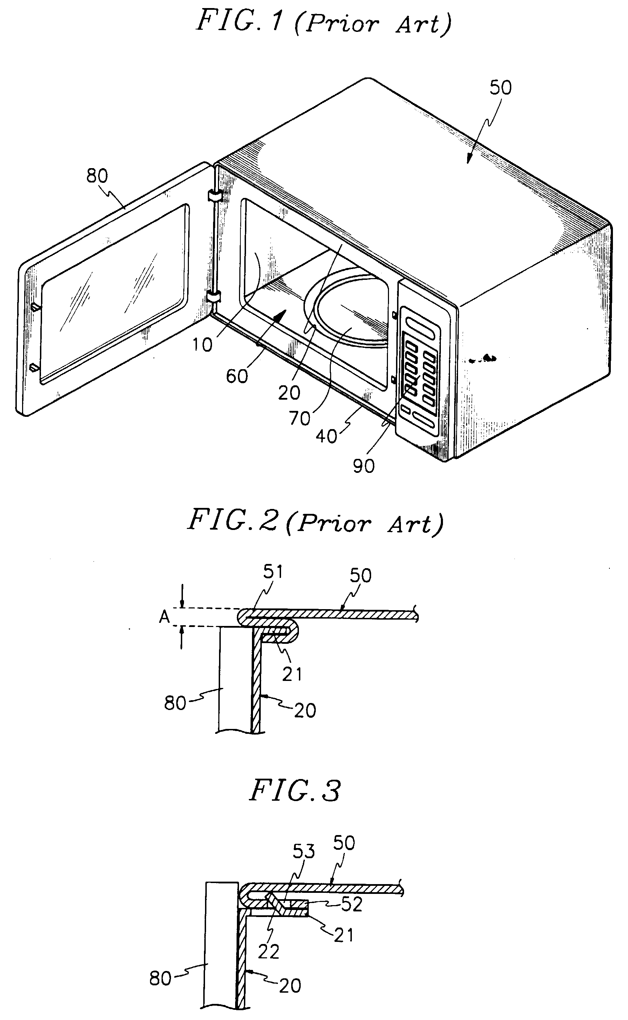

Figures 1 and 2 show a known microwave oven. Referring to Figures 1 and 2, the microwave oven comprises a front panel 20, a back panel 30, a cover 50, a cooking chamber 60, having walls 10 and closed by a door 80, and a control unit 90.

A flange 21 extends horizontally back from the top of the front panel 30. The front edge 51 of the top panel of the case 50 is bend back on itself and then forward so that it has s-section. During assembly, the flange 21 is forced between the folds of the front edge 51 of the cover 50.

A disadvantage of this construction is that the front edge 51 of the cover 50 is visible over the door 80 when it is closed. This visible portion A is unattractive.

A casing according to the present invention, is characterised in that the upper and wall panels are joined along adjacent edges and the upper panel is not proud of the door.

Preferably, the joined edge of the upper panel is folded back on itself, the folded back portion having a slot therein, and the wall panel has a flange, projecting rearwardly from its upper edge, having a forwardly projecting tongue inserted into the slot.

The present invention finds application in the construction of a microwave oven, in which case the door is the door of the oven's cooking chamber.

An embodiment of the present invention will now be described, by way of example, with reference to Figure 3 of the accompanying drawings:-
Figure 1 is a front perspective view of a microwave oven;
Figure 2 is a partial sectional view of the door and upper panel joint of a known microwave oven; and
Figure 3 is a partial sectional view of the door and upper panel joint of the microwave oven according to the present invention.

Referring to Figure 3, the front panel 20 and the upper panel 50 of a microwave oven are coupled together. The front panel 20 is provided at its upper edge with a horizontal, rearwardly extending portion 21. The rearwardly extending portion 21 has a cut-out tongue 22 projecting forwards and upwards. The front edge of the upper panel 50 has a portion 52 that is first bent downwards and then backwards so that the front edge of the upper panel has a U-shaped cross-section. The bent portion 52 has a slot 53 through which the tongue 22 projects.

It is to be noted that the front edge of the upper panel 50 is vertically aligned with a front face of the front panel 20.

The assembly of the above-described microwave oven will now be described.

The front panel 20 is coupled to the front of the cavity 10. Then, the cover, including the upper panel 50, is put in position. Consequently, the bent portion 52 rests on the rearwardlty extending projection 21 and the tongue 22 projects into the slot 53. The cover is then moved rearwards until the bent portion 52 is vertically aligned with the front face of the front panel 20. As a result, the tongue 22 and the slot 53 combine to hold the front panel 20 and the upper panel together.

When the door 80 has been mounted and closed, the top of the door 80 is level with the upper surface of the upper panel 50. Consequently, the appearance of the oven from the front is attractive.

## Claims

1. A casing having an upper panel (50), a wall panel (20) and a door (80) configured to close against the wall panel (20), **characterised in that** the upper and wall panels (50, 20) are joined along adjacent edges and the upper panel is not proud of the door (80).

2. A casing according to claim 1, wherein the joined edge of the upper panel is folded back on itself, the folded back portion (52) having a slot (53) therein, and the wall panel (20) has a flange (21), projecting rearwardly from its upper edge, having a forwardly projecting tongue (22) inserted into the slot.

3. A microwave oven having a casing according to claim 1 or 2, wherein the door (80) is the door of the oven's cooking chamber (60).

4. An outer panel assembling apparatus adapted to couple an upper end of a front panel and a front end of an outer panel,
characterised in that when seen from the front view of a microwave oven, said upper end of a front panel and the front end of an outer panel are coupled by mean of projection and slot such that a top end of a door and a top end of the outer panel are horizontally aligned.

5. The apparatus of claim 4, wherein the projection is formed in a horizontally and rearward bent portion of the front panel, relative to plane of the front panel.

6. The apparatus of any one of claims 4 and 5, wherein the projection is upwardly inclined in a front end of the projection.

7. The apparatus of claim 4, wherein the slot is formed in a portion bent like a U-turn shape, said bent portion constituting a front portion of the outer panel.
